Europäisches Patentamt

European Patent Office

Office européen des brevets

(19)

(11) Veröffentlichungsnummer: **0 262 549**
**B1**

(12) # EUROPÄISCHE PATENTSCHRIFT

(45) Veröffentlichungstag der Patentschrift:
19.09.90

(51) Int. Cl.⁵: **H05K 7/12**

(21) Anmeldenummer: 87113789.9

(22) Anmeldetag: 21.09.87

(54) Halter für lichtemittierende Dioden.

(30) Priorität: 03.10.86  DE 8626927 U

(43) Veröffentlichungstag der Anmeldung:
06.04.88 Patentblatt 88/14

(45) Bekanntmachung des Hinweises auf die Patenterteilung:
19.09.90 Patentblatt 90/38

(84) Benannte Vertragsstaaten:
AT CH DE ES FR GB IT LI SE

(56) Entgegenhaltungen:
DE-A- 2 714 168
DE-A- 2 718 442
DE-U- 8 530 418
US-A- 4 065 198

(73) Patentinhaber: Siemens Aktiengesellschaft,
Wittelsbacherplatz 2, D-8000 München 2(DE)

(72) Erfinder: Donhauser, Peter, Dipl.-Ing. (FH),
Hallstätterstrasse 24, D-8450 Amberg(DE)
Erfinder: Schirbl, Reinhard, Kreuzfelderstrasse 2,
D-8460 Schwandorf(DE)

## Beschreibung

Die Erfindung bezieht sich auf einen Halter für lichtemittierende Dioden mit einem an einer Schaltungsplatine befestigbaren Auflageblock, der Ausnehmungen und Nuten zum Durchführen der Anschlüsse für die Dioden und Halterungen für die Diode aufweist.

Bei einem bekannten Halter der obengenannten Art (US-PS 4 065 198) wird die Leuchtdiode mit ihren Anschlüssen durch Ausnehmungen im Halter gefädelt, bis die Leuchtdiode zur Anlage am Auflageblock kommt. Die vorstehenden Anschlüsse werden dann mit einem zusätzlichen Deckteil um 90° in Nuten abgebogen.

Bei einem weiterhin bekannten Halter der obengenannten Art (DE-OS 35 38 187) liegt die Längsachse quer zur Oberfläche der Schaltungsplatine und die lichtemittierenden Dioden sind in einem Mehrfachhalter mit dem Rand des Diodenkörpers verrastet. Die Anschlüsse sind hier durch Zuführungsleitungslöcher im Auflageblock hindurchgeführt.

Der Erfindung liegt die Aufgabe zugrunde einen Halter der obengenannten Art dahingehend zu verbessern, daß die LED im Gurt gebogen und automatisch in die Rückseite des Halters eingeführt werden kann. Dies wird auf einfache Weise dadurch erreicht, daß der Auflageblock parallel zu seiner Befestigungsebene verlaufend eine von der die Anschlüsse aufnehmenden Seite zugänglichen Aufnahmebohrung für den Körper der Diode und quer dazu Nuten zur Aufnahme der senkrecht zur Längsachse der Diode abgewinkelten Anschlüsse aufweist. Hierdurch ist eine einfache automatische Bestückung von gegurteten und ungegurteten Dioden möglich. Um ein Zurückrutschen der lichtemittierenden Dioden aus der Aufnahmebohrung zu verhindern und zur exakten Fixierung des Rasterabstandes der Diodenanschlüsse zum Befestigungsstift ist es vorteilhaft, wenn die Nuten Rastnasen aufweisen, die mit den Anschlüssen verrastbar sind. Um auch Körper mit unterschiedlichen Toleranzen entsprechend der gewünschten Austrittsrichtung zentrieren zu können ist es weiterhin von Vorteil, wenn die Aufnahmebohrung von zumindest zwei elastisch nachgiebigen Teilringwänden begrenzt ist. Die Verrastung der Auflageblöcke mit der Schaltungsplatine wird entbehrlich, wenn an den Auflageblöcken zur Befestigung an der Schaltungsplatine quadratisches Profil aufweisende Stifte angeformt sind, deren Diagonalen etwas größer als die Durchmesser der Befestigungslöcher in der Schaltungsplatine sind.

Anhand der Zeichnung wird ein Ausführungsbeispiel gemäß der Erfindung beschrieben.

Es zeigen:

Fig. 1 eine perspektivische Darstellung der auf der Schaltungsplatine angeordneten Halter mit lichtemittierenden Dioden,

Fig. 2 eine Vorderansicht auf den Auflageblock mit eingesetzter Diode,

Fig. 3 eine Schnittdarstellung gemäß der Linie III-III der Fig. 2,

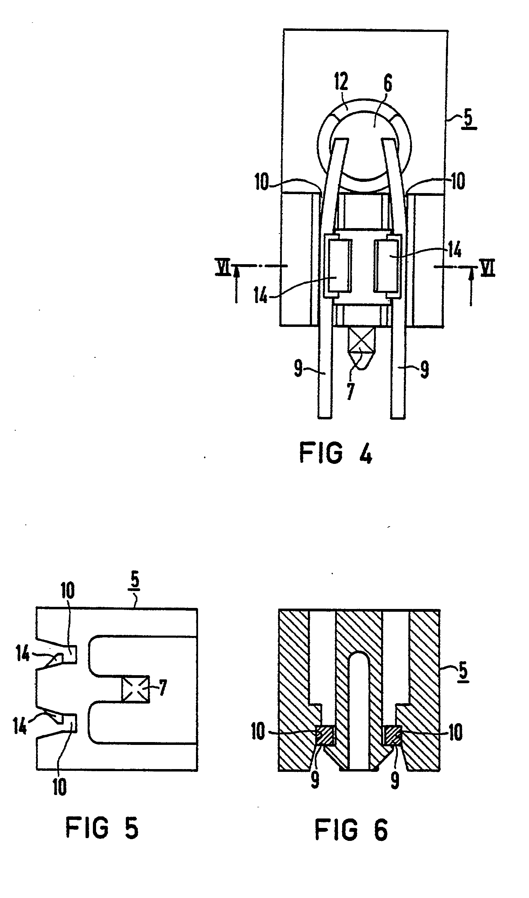

Fig. 4 eine Rückansicht,

Fig. 5 eine Unteransicht und

Fig. 6 eine Schnittdarstellung gemäß der Linie V-V nach Fig. 4.

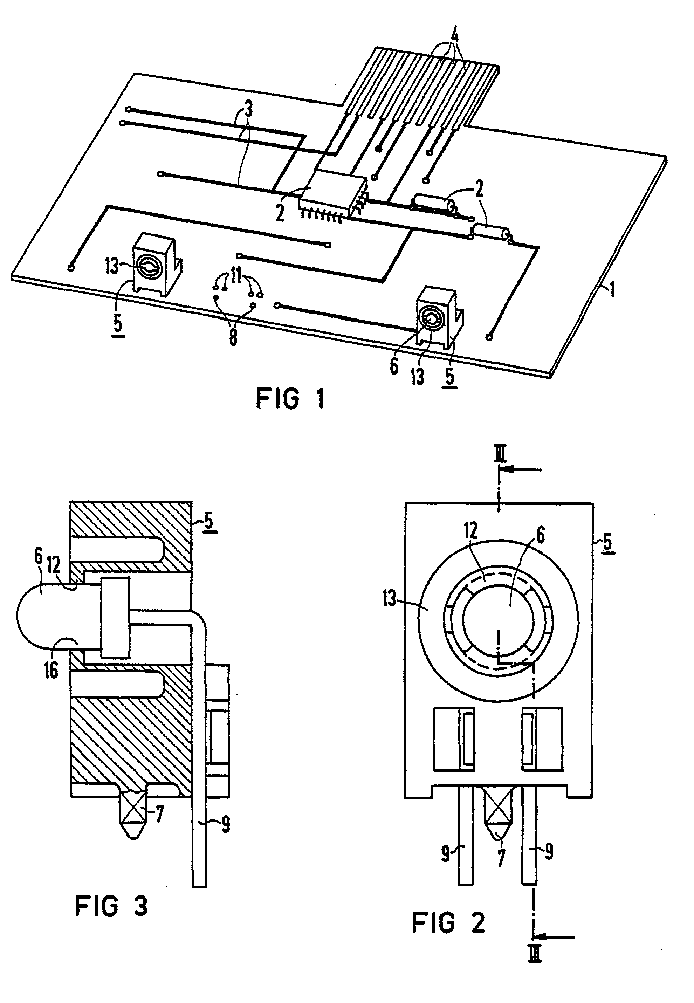

Auf der in der Zeichnung dargestellten Schaltungsplatine 1 sind die Bauelemente 2 über die Leiterbahnen 3 und die Steckanschlüsse 4 miteinander verbunden. Den Steckanschlüssen 4 gegenüberliegend sind Auflageblöcke 5 zur Aufnahme der lichtemittierenden Dioden 6 befestigt. Zur Befestigung der Auflageblöcke 5 dienen - wie aus Fig. 2 und 3 ersichtlich - quadratischen Querschnitt aufweisende Stifte 7, die in Rundlöcher 8 der Platine 1 eingeschoben sind. Die Diagonale des quadratischen Querschnittes der Stifte 7 ist etwas größer als der Durchmesser der Rundlöcher 8, so daß die Auflageblöcke 5 stoffschlüssig mit der Schaltungsplatine verbunden sind. Die lichtemittierenden Dioden 6 weisen Anschlüsse 9 auf, die in Nuten 10 der Auflageblöcke - siehe Fig. 3 - geführt sind und über die Auflageblöcke 5 hinausragen. Die freien Enden werden in die Kontaktierungslöcher der Schaltungsplatine 1 eingeschoben und können dann von der Rückseite her verlötet werden. Der Körper 12 der lichtemittierenden Diode 6 wird an seinem Außenumfang durch elastisch nachgiebige Teilringwände 12 zentrierend gehalten. Die Teilringwände 12 sind durch eine entsprechende ringförmige Aussparung 13 - siehe Fig. 2 - gebildet. Die Anschlüsse 8 sind gegenüber der Längsachse der lichtemittierenden Dioden 6 senkrecht abgebogen - siehe hierzu Fig. 3. Rastnasen 14 ragen in die Nuten 10 hinein. Bei entsprechender Ausbildung können die Anschlüsse 9 gegen die Wandung 15 der Nut 10 drücken. Dadurch, daß der Körper 16 der lichtemittierenden Diode 6 zwischen den Teilringwänden 12 geführt ist, ist eine bestimmte Lage der lichtemittierenden Diode 6 zur Schaltungsplatine 1 gegeben. Durch das Einrasten der Anschlüsse 9 hinter den Rastnasen 14 ist bei definierter Abbiegung der Anschlüsse gegenüber der Längsachse der lichtemittierenden Diode auch der Grad des Durchreichens des Körpers 16 durch den Auflageblock genau definiert. Dioden in gegurteter oder ungegurteter Bauform, bei welchen vorher die Anschlüsse rechtwinklig abgebogen wurden, können einfach in den Auflageblock der beschriebenen Ausführung automatisch bestückt werden.

## Patentansprüche

1. Halter für lichtemittierende Dioden mit einem an einer Schaltungsplatine befestigbaren Auflageblock, der Ausnehmungen und Nuten zum Durchführen der Anschlüsse für die Dioden und Halterungen für die Dioden aufweist, **dadurch gekennzeichnet,** daß der Auflageblock (5) parallel zu seiner Befestigungsebene verlaufend eine von der die Anschlüsse aufnehmenden Seite zugänglichen Aufnahmebohrung für den Körper (16) der Diode (6) und quer dazu Nuten (10) zur Aufnahme der senkrecht zur Längsachse der Diode abgewinkelten Anschlüsse (9) aufweist.

2. Halter nach Anspruch 1, **dadurch gekennzeich-**

net, daß die Nuten (10) Rastnasen (14) aufweisen, die mit den Anschlüssen (9) verrastbar sind.

3. Halter nach Anspruch 1 oder 2, **dadurch gekennzeichnet,** daß die Aufnahmebohrung von zumindest zwei elastisch nachgiebigen Teilringwänden (12) begrenzt ist.

4. Halter nach Anspruch 1, 2 oder 3, **dadurch gekennzeichnet,** daß an den Auflageblöcken (5) zur Befestigung an der Schaltungsplatine (1) quadratisches Profil aufweisende Stifte (7) angeformt sind, deren Diagonalen etwas größer als die Durchmesser der Befestigungslöcher (8) in der Schaltungsplatine (1) sind.

5. Halter nach einem der vorhergehenden Ansprüche, **dadurch gekennzeichnet,** daß in an sich bekannter Weise mehrere Auflageblöcke (5) zu einem Block zusammengefaßt sind.

## Claims

1. Holder for light-emitting diodes, with a supporting block which can be attached to a circuit board, and which has recesses and slots for leading through the connections for the diodes, and mounts for the diodes, characterised in that the supporting block (5) has a location bore hole for the body (16) of the diode (6), which location bore hole extends parallel to the plane of attachment of the supporting block (5) and is accessible from the side which receives the connections, and in that the supporting block (5) has, transversely to this location bore hole, slots (10) for receiving the connections (9), which connections (9) are bent perpendicularly to the longitudinal axis of the diode.

2. Holder according to claim 1, characterised in that the slots (10) have catching lugs (14) which lock on to the connections (9).

3. Holder according to claim 1 or 2, characterised in that the location bore hole is bounded by at least two elastic, flexible partial ring walls (12).

4. Holder according to claim 1, 2 or 3, characterised in that pins (7) having a square section are integrally moulded to the supporting blocks (5) for attachment to the circuit board (1), the diagonals of these pins (7) being approximately larger than the diameter of the attachment holes (8) in the circuit board (1).

5. Holder according to one of the preceding claims, characterised in that several supporting blocks (5) are assembled in known manner into one block.

## Revendications

1. Support pour diodes photoémissives, comportant un bloc, qui peut être fixé à une platine porte-circuits et possède des évidements et des rainures pour le passage des bornes de raccordement pour les diodes et les supports pour ces dernières, caractérisé par le fait que le bloc de support (5) comporte un perçage récepteur pour le corps (16) de la diode (6), qui est accessible à partir du côté de réception des bornes et parallèle au plan de fixation du bloc, et, transversalement par rapport à cette direction, des rainures (10) servant à loger les bornes (9) recourbées perpendiculairement par rapport à l'axe longitudinal de la diode.

2. Support selon la revendication 1, caractérisé par le fait que les rainures (10) comportent des becs d'encliquetage (14), qui peuvent se verrouiller par encliquetage sur les bornes (9).

3. Support suivant la revendication 1 ou 2, caractérisé par le fait que le perçage récepteur est délimité par au moins deux parois annulaires partielles (12), qui fléchissent élastiquement.

4. Support suivant la revendication 1, 2 ou 3, caractérisé par le fait que sur les blocs de support (5) sont formées, par moulage, des broches (7) possédant un profil carré et utilisées pour la fixation sur la platine porte-circuits (1) et dont les diagonales sont d'une taille légèrement supérieure au diamètre des trous de fixation (8) ménagés dans la platine porte-circuits (1).

5. Support suivant l'une des revendications précédentes, caractérisé par le fait que plusieurs blocs de support (5) sont réunis de façon connue en soi pour former un bloc.

FIG 1

FIG 3

FIG 2

FIG 4

FIG 5

FIG 6